# EUROPÄISCHE PATENTSCHRIFT

(11) **EP 2 282 349 B1**
(45) Veröffentlichungstag und Bekanntmachung des Hinweises auf die Patenterteilung: **12.10.2016**
(21) Anmeldenummer: 10008183.5
(22) Anmeldetag: 05.08.2010
(51) Int. Cl.: H01L 31/02, H02S 40/34

(54) **Solarmodul und Verfahren zur Herstellung desselben**
Solar module and method for manufacturing the same
Module solaire et son procédé de fabrication

(30) Priorität: 06.08.2009 DE 102009036458
(43) Veröffentlichungstag der Anmeldung: 09.02.2011
(73) Patentinhaber: Yamaichi Electronics Deutschland GmbH, 85609 Aschheim-Dornach (DE)
(72) Erfinder: Eberle, Erwin, 80687 München (DE); Quiter, Michael, 57482 Wenden (DE)
(74) Vertreter: Müller-Boré & Partner Patentanwälte PartG mbB

(56) Entgegenhaltungen:
- EP-A1- 1 006 593
- WO-A1-03/041227
- DE-A1- 19 813 324
- DE-A1-102007 032 603
- US-A- 4 457 578

## Beschreibung

Die vorliegende Erfindung betrifft ein Solarmodul und ein Verfahren zum Herstellen desselben.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt.

Die elektrischen Anschlüsse der Solarzellengruppen des Solarmoduls werden nach außen geführt. Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten:
(1) Eine (gleichmäßige) Verringerung der Bestrahlungsintensität innerhalb der zusammen geschalteten Solarzellengruppen führt zu einer Leistungsverminderung der jeweiligen Solarzellengruppe.
(2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle führen kann und damit zum dauerhaften Ausfall der Solarzellengruppe.

In jedem Fall können zwischen den herausgeführten Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden verwendet, die elektrisch antiparallel zu den Solarzellengrüppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlüsse dieser Solarzellengruppe eines Solarmoduls werden durch die Bypass-Diode kurz geschlossen und die entsprechende Solarzellengruppe dadurch überbrückt. Somit liefert eine solche Solarzellengruppe zwar keinen Anteil mehr zur Gesamtleistung des Solarmoduls, der Gesamtstromfluss durch das Solarmodul ist jedoch im Wesentlichen ungehindert und eine Beschädigung einzelner Solarzellen wird verhindert.

Solarmodule umfassen daher in der Regel eine elektrische Anschlussdose mit einer Vielzahl von Kontaktvorrichtungen und einer entsprechend angepaßten Anzahl von Bypass-Dioden. Dünne flexible Leiterbänder, welche mit den einzelnen Solarzellengruppen elektrisch verbunden sind, sind aus dem Solarmodul heraus geführt und in der Regel mit den in der einen Anschlussdose angeordneten Kontaktvorrichtungen kontaktiert, die untereinander mit Bypass-Dioden elektrisch verbunden sind.

Um die Leiterbänder anschließen zu können, werden diese üblicherweise von unten her in die Anschlussdose eingeführt, die einen abnehmbaren Gehäusedeckel aufweist, und von Hand mit einer in der Anschlussdose vorhandenen Kontaktvorrichtung kontaktiert.

Eine derartige manuelle Montage ist sehr zeitintensiv, wodurch sich ein Bedarf nach einem automatisierten Anschließen eines Solarmoduls ergibt. Aufgrund der hohen Flexiblität stehen die aus dem Solarmodul herausgeführten Leiterbänder jedoch ungeordnet von der Rückseite des Solarmoduls ab. Eine Positionsbestimmung der Leiterbänder, die für eine automatisierte Montage erforderlich ist, ist somit sehr erschwert.

Aus der DE 10 2007 051 134 A1 ist eine Anschluss- und Verbindungsdose für ein Solarmodul bekannt, die ein Gehäuse zum Aufsetzen auf das Sofarmodul umfasst. In dem Gehäuse ist eine Anschlussvorrichtung für die flexiblen Leiterbänder angeordnet, wobei die Anschlussvorrichtung eine elektrische Kontaktklemme zum Herstellen eines Klemmkontakts aufweist. Ein Umlenkhebel biegt das flexible Leiterband nach einem Einführen durch eine Einführöffnung in die Anschluss- und Verbindungsdose zu der Kontaktklemme hin um, so dass das flexible Leiterband nach dem Umbiegen mittels der Kontaktklemme elektrisch kontaktierbar ist.

Aus der DE 10 2007 032 603 A1 ist ein Anschlusskontakt zum Aufbringen auf einer Leiterplatte an einem Photovoltaikpaneel bekannt. Der Anschlusskontakt weist eine L-Form auf, wobei der Grundschenkel direkt auf der Leiterplatte aufgelötet ist und ein Längsschenkel senkrecht zu der Leiterplatte nach oben ragt. Im Bereich des Längsschenkels des Anschlusskontakts wird eine mit Schlitzen versehene Laminatfolie derart über die Anschlusskontakte gelegt, dass der Längsschenkel durchsetzt, bis die Laminatfolie auf dem Photovoltaikpaneel und der Leiterplatte aufliegt.

Ferner ist aus der EP 1 006 593 A1 eine photovoltaisches Solarmodul bekannt. Das Solarmodul weist eine Außenplatte, eine Innenplatte und eine die beiden Platten verbindende Zwischenschicht auf, in die die Solarzellen eingebettet sind. Die Solarzellen sind über mehrere Verbindungsleiter elektrisch miteinander verschaltet, wobei die Verbindungsleiter jeweils mit einer in einer Öffnung in der Innenplatte angeordneten Anschlusseinrichtung elektrisch leitend verbunden sind, wobei die Anschlusseinrichtung einen mehrpoligen Steckverbinder umfasst.

Die US 4,457,578 A offenbart einen elektrischen Anschluss zur Verwendung in einem laminierten photovoltaischen Solarpaneel. Der Anschluss umfasst einen Anschlussstab, welcher ein erstes Ende zur Verbindung mit einem externen elektrischen Leiter und ein zweites geplättetes Ende, um einen Flange auszuformen, umfasst. Eine flache Anschlussplafte, welche eine Öffnung aufweist, durch welches das erste Ende des Stabs angeordnet wird, um sich von einer ersten Seite der Platte zu erstrecken, während der Flansch an der zweiten Seite der Platte angeklebt ist.

Ferner offenbart die WO 03/041227 A1 eine Anordnung umfassend ein paneelartig aufgebautes elektrisches Modul. Mittel zum Kontaktieren von Anschlußabschnitten des Moduls sind aus der Ebene der Leiterbahnstruktur herausgebogen und sind ein Teil der Leiterbahnstruktur darstellenden Anschlußabschnitte und die Anschlußabschnitte des Moduls sind starre und aus der Ebene der Leiterbahnstruktur des Moduls herausbiegbare elektrische Leiterbahnabschnitte. Die Anschlußabschnitte der Anschlußeinheit sind entsprechend der Anordnung der Anschlußabschnitte des Moduls angeordnet, so daß, wenn die Anschlußeinheit mit dem Modul verbunden ist, ein Anschlußabschnitt des Moduls und einer der Anschlußeinheiten elektrisch miteinander verbunden sind, in einem Abschnitt aneinander grenzen und im Bereich des Aneinandergrenzens in einer anderen Raumlage als diejenige der Ebenen der Leiterbahnstrukturen angeordnet sind.

Es ist daher die Aufgabe der vorliegenden Erfindung ein Solarmodul und ein Verfahren zum Herstellen desselben bereitzustellen, in dem Leiterbänder leichter und schneller kontaktiert werden können, wobei die Kontaktierung mit einer hohen Kontaktsicherheit erfolgt.

Diese Aufgabe wird durch die unabhängigen Ansprüche gelöst. Bevorzugte Ausführungsformen sind Gegenstand der abhängigen Ansprüche.

Ein Aspekt der vorliegenden Erfindung betrifft ein Solarmodul umfassend:
eine Vielzahl von Solarzellen, die mit zumindest einem Leiterband elektrisch leitend verbunden sind, wobei die Solarzellen und das Leiterband zumindest teilweise innerhalb einer Laminierschicht angeordnet sind, und
zumindest ein Kontaktstück, das separat von dem Leiterband ausgebildet ist, wobei ein erstes Ende des Kontaktstücks elektrisch leitend mit einem freien Ende des Leiterbands kontaktiert ist und wobei die Kontaktstelle zwischen dem Leiterband und dem Kontaktstück in eine Laminierschicht eingebettet ist, wobei ein zweites Ende des Kontaktstücks aus der Laminierschicht herausgeführt ist, und wobei das Leiterband auf einer Fläche des Solarmoduls verläuft und ein vorderer Abschnitt eines freien Endes des Leiterbands im Wesentlichen senkrecht zu der Fläche des Solarmoduls aufgebogen ist und als Kontaktfläche mit dem Kontaktstück dient.

Das Solarmodul umfasst zumindest eine, d.h. 1, 2, 3, 4, 5, 6, 7, 8, 9, 10, usw. gegebenenfalls in Reihe geschaltete spannungserzeugende Solarzelle(n) bzw. Solarzellengruppe(n), wobei jede Solarzelle vorzugsweise zwei Leiterbänder aufweist, die den Plus- und Minuspol der Solarzelle bilden und die an einer Anschlussseite des Solarmoduls aus diesem herausgeführt werden. Folglich umfasst ein Solarmodul vorzugsweise zumindest zwei, d.h. 2, 4, 6, 8, 10, 12, 14, 16, 18, 20 usw. Leiterbänder. Die "Anschlussseite bzw. -fläche" im Sinne der Erfindung beschreibt eine Seite bzw. Fläche, die insbesondere einer lichtaktiven Seite bzw. Fläche gegenüberliegt. In anderen Worten ist die lichtaktive Seite bzw. Fläche ausgelegt, Licht aufzunehmen bzw. in das Solarmodul zu führen. Die "Anschlussseite bzw. -fläche" ist insbesondere die Rückseite des Solarmoduls, mittels welcher das Solarmodul beispielsweise befestigt bzw. montiert werden kann.

Vorzugsweise ist das Leiterband bandförmig bzw. flach ausgestaltet. Dabei weist das Leiterband insbesondere ein Verhältnis von Breite zu Dicke von größer als 2, besonders bevorzugt größer als 5, größer als 10, größer als 20, größer als 50 und insbesondere größer als 100 auf.

Vorzugsweise ist das zumindest eine Leiterband als Folienleiter ausgebildet, d.h. als ein Verbund aus einer Polymerfolie mit einem daran befestigten elektrischen Leiter, wobei die Befestigung insbesondere mittels Aufdampfen oder Aufkleben an die Polymerfolie erfolgt ist.

Das zumindest eine Kontaktstück ist aus einem Material mit guter elektrischer Leitfähigkeit hergestellt, wie beispielsweise Kupfer oder Silber. Aufgrund einer größeren Dicke und der Materialauswahl ist das erfindungsgemäße Kontaktstück starr. Diese Eigenschaft wird erfindungsgemäß dazu genutzt, dass das Kontaktstück als Kupplungsstück zwischen dem Leiterband und einer in Folge angeschlossenen Anschlussvorrichtung dient. Eine Kontaktierung zwischen der Anschlussvorrichtung und dem Leiterband wird damit mittels des starren Kontaktstücks, dessen Position eindeutig bestimmt werden kann, deutlich vereinfacht, wodurch eine Automatisierung des Herstellungsprozesses möglich ist.

Unter dem Begriff "separat" wird erfindungsgemäß eine getrennte Herstellung des Leiterbands und des Kontaktstücks verstanden, so dass es sich bei den genannten Elementen um getrennte Elemente handelt, die beispielsweise nicht integral miteinander ausgeformt sind.

Vorzugsweise ist das freie Ende des Leiterbands somit in einer L-Form ausgebildet. Unter einem "freien Ende eines Leiterbands" im Sinne der Erfindung ist der Abschnitt des Leiterbands zu verstehen, der anschlussseitig aus dem Solarmodul herausgeführt ist. Der vordere aufgebogene Abschnitt des freien Endes bildet die Kontaktstelle zwischen dem Kontaktstück und dem Leiterband, wobei dieser Kontakt mittels der Laminierschicht dauerhaft gehalten wird, indem die Kontaktstelle in die Laminierschicht eingebettet ist. Vorzugsweise handelt es sich bei der "Fläche des Solarmoduls" um die Anschlussseite des Solarmoduls.

Des Weiteren weist das Leiterband vorzugsweise in einem Bereich nahe dem Kontaktstück zumindest eine Wölbung oder Rippe auf. Derartige Wölbungen oder Rippen in dem Leiterband sollen dem einzelnen Leiterband eine zusätzliche Länge verleihen, die dann zum Einsatz kommt, wenn beispielsweise während der Montage des Solarmoduls oder während Wartungsarbeiten versehentlicherweise an dem Leiterband gezogen oder gerissen wird. Die durch eine Wölbung oder Rippe gewonnene zusätzliche Strecke ermöglicht, dass zunächst die zumindest eine Wölbung oder Rippe glatt gezogen würde, jedoch die Kontaktierung zwischen dem Leiterband und dem Kontaktstück weiter gewährleistet ist. Des Weiteren schafft die zumindest eine Wölbung oder Rippe eine höhere Fixierkraft innerhalb der Laminierschicht.

Vorzugsweise umfasst das Solarmodul ferner zumindest ein Federelement, wobei das Federelement das Kontaktstück gegen das Leiterband an deren Kontaktstelle drückt und vorzugsweise im Wesentlichen eine U-Form aufweist. Mittels der zusätzlichen Unterstützung durch das Federelement an der Kontaktstelle zwischen dem Leiterband und dem Kontaktstück wird die Kontaktsicherheit weiter verbessert. Insbesondere ist das Langzeitverhalten des Federelements, welches vorzugsweise aus einem Federstahl hergestellt ist, bekannt, wodurch eine dauerhafte Kontaktsicherheit gewährleistet werden kann.

Weiters bevorzugt sind die Solarzellen in einer ersten Laminierschicht eingebettet sind, und/oder das freie Ende des Leiterbands zumindest teilweise in einer zweiten Laminierschicht eingebettet.

Vorzugsweise umfasst das Solarmodul ferner ein Anschlussdosengehäuse umfassend ein Bodenelement, das auf dem Solarmodul angeordnet ist, und eine Deckelelement, wobei das freie Ende des Leiterbands in zumindest einer Öffnung des Bodenelements auf der Fläche des Solarmoduls verläuft.

Ferner ist die zweite Laminierschicht vorzugsweise nur im Bereich der Öffnung in dem Bodenelement angeordnet ist.

Weiters bevorzugt ist ein erstes Ende des Kontaktstücks im Wesentlichen senkrecht zu der Fläche des Solarmoduls und/oder parallel zu dem aufgebogenen Abschnitt des Leiterbands angeordnet und ein zweites Ende des Kontaktstücks verläuft im Wesentlichen parallel zu der Fläche des Solarmodul.

Vorzugsweise kontaktiert das Kontaktstück eine Anschlussvorrichtung elektrisch leitend.

Ein weiterer Aspekt der vorliegenden Erfindung betrifft ein Verfahren zum Herstellen eines Solarmoduls mit einer Vielzahl von Solarzellen, umfassend die Schritte:
elektrisch leitendes Verbinden der Solarzellen mittels zumindest einem Leiterband,
Bereitstellen von zumindest einem separaten Kontaktstück,
elektrisch leitendes Kontaktieren eines freien Endes des Leiterbands mit einem ersten Ende des Kontaktstücks, und
Aufbringen einer Laminierschicht derart, dass sowohl die Kontaktstelle zwischen dem Leiterband und dem Kontaktstück als auch zumindest teilweise das freie Ende des Leiterbands in eine Laminierschicht eingebettet sind und ein zweites Ende des Kontaktstücks aus der Laminierschicht herausragt,
wobei das Verfahren ferner den Schritt eines Biegens des freien Endes der Leiterbänder, so dass das Leiterband auf einer Fläche des Solarmoduls verläuft und ein vorderer Abschnitt des freien Endes des Leiterbands im Wesentlichen senkrecht zu der Fläche des Solarmoduls aufgebogen ist.

Vorteilhafterweise umfasst das Verfahren ferner den Schritt eines Prägens zumindest einer Wölbung oder Rippe in das Leiterband, in einem Bereich nahe dem Kontaktstück.

Weiters bevorzugt umfasst das Verfahren ferner die Schritte:
Bereitstellen von zumindest einem Federelement;
Kontaktieren des Federelements mit dem Kontaktstück, so dass das Federelement gegen eine Fläche des Kontaktstücks drückt, die der Kontaktstelle zwischen dem Leiterband und dem Kontaktstück entgegengesetzt ist.

Vorzugsweise umfasst der Schritt des Laminierens:
Aufbringen einer ersten Laminierschicht, in die die Solarzellen eingebettet werden, und/oder
Aufbringen einer zweiten Laminierschicht, in die das freie Ende des Leiterbands zumindest teilweise eingebettet wird.

Diese und andere Ziele, Merkmale und Vorteile der vorliegenden Erfindung werden bei der Lektüre der nachfolgenden detaillierten Beschreibung von bevorzugten Ausführungsformen und aus beigefügten Zeichnungen deutlicher ersichtlich werden. Es sollte verstanden werden, dass, obwohl Ausführungsformen getrennt beschrieben werden, einzelne Merkmale davon zu zusätzlichen Ausführungsformen kombiniert werden können.
- Figur 1: zeigt eine schematische Vorderansicht eines Solarmoduls;
- Figur 2: zeigt eine perspektivische Ansicht des Anschlussdosengehäuses mit geschlossenem Deckelelement;
- Figur 3: zeigt eine perspektivische Ansicht des Anschlussdosengehäuses, insbesondere der Anschlussvorrichtung, mit abgenommenen Deckelelement;
- Figur 4: zeigt eine perspektivische Ansicht des Bodenelements des Anschlussdosengehäuses mit der Kontaktierungseinheit, in der die Kontaktstellen zwischen den Leiterbändern und den Kontaktstücken in eine Laminierschicht eingebettet sind;
- Figur 5: zeigt eine perspektivische Ansicht des Bodenelements des Anschlussdosengehäuses mit der Kontaktierungseinheit nach Figur 4 ohne die erfindungsgemäße Laminierschicht;
- Figur 6: zeigt eine Vorderansicht der Kontaktierungseinheit.

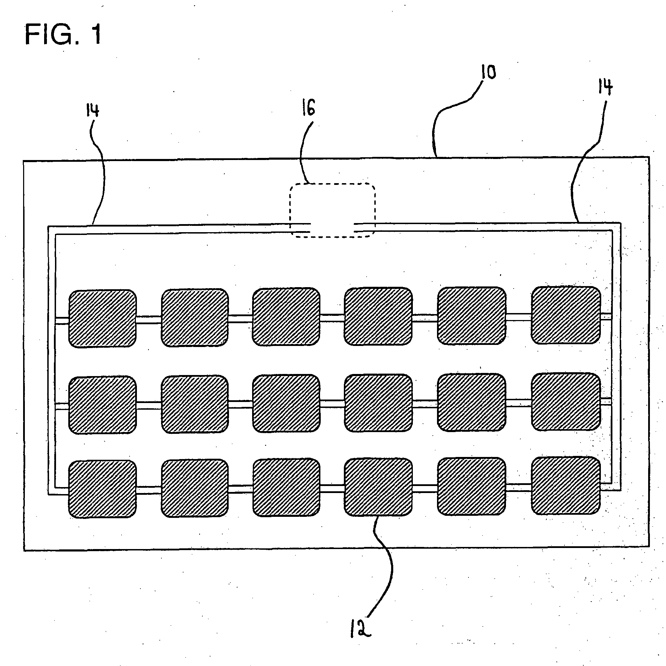

Figur 1 zeigt eine Vorderansicht eines Solarmoduls 10 mit einer Vielzahl von Solarzellen 12 mit drei parallel geschalteten Solarzellengruppen, die mittels Leiterbändern 14 miteinander verschaltet sind. Die zwei freien Enden der Leiterbänder 14 sind aus der Rückseite des Solarmoduls heraus in ein Anschlussdosengehäuse 16 (hier nur angedeutet) zur Kontaktierung mit einer Anschlussvorrichtung geführt.

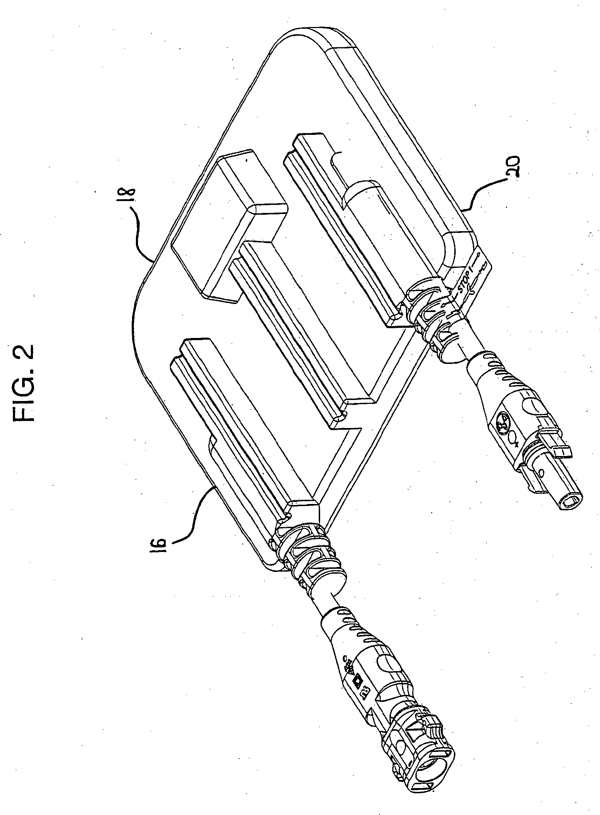

Figur 2 zeigt eine perspektivische Ansicht des Anschlussdosengehäuses 16, das in seinem montierten Zustand an der Rückseite des Solarmoduls 10 befestigt ist, vorzugsweise mittels zusätzlicher Befestigungselemente und/oder damit verklebt ist. Das Anschlussdosengehäuse 16 umfasst ein abnehmbares Deckelelement 18 und vorzugsweise ein im Wesentlichen flaches Bodenelement 20, das an der Rückseite des Solarmoduls 10 befestigt wird. Insbesondere kann hierzu ein Haftmittel auf dem Bodenelement 20 aufgetragen sein. Das Haftmittel kann beispielsweise einen Haftkleber und/oder einen Schmelzkleber und/oder ein Klebeband umfassen. Vorzugsweise sind die Elemente des Anschlussdosengehäuses 16 aus Kunststoff bzw. aus einem Polymer gespritzt. Figur 2 zeigt das Anschlussdosengehäuse 16 mit geschlossenem Deckelelement 18, das einzelne Aussparungen aufweist, in welchen beispielsweise die einzelnen Dioden oder die Kontaktierungseinheit aufgenommen werden.

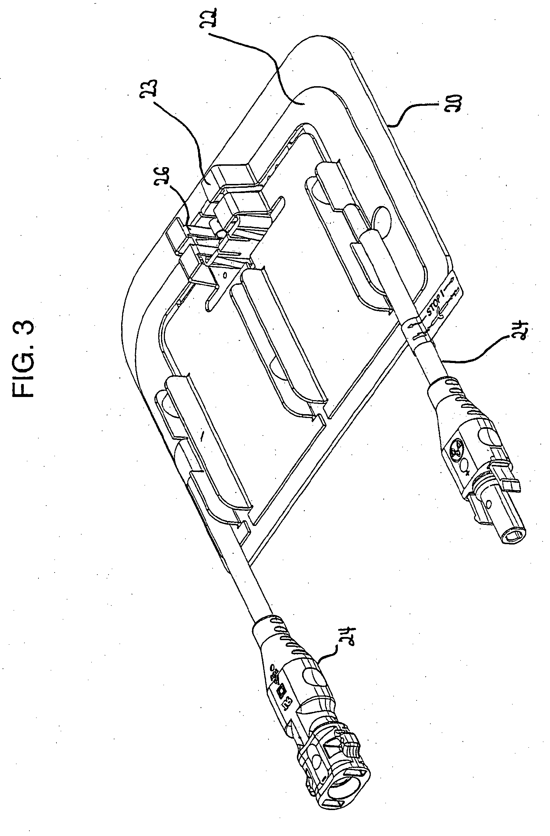

Figur 3 zeigt das Anschlussdosengehäuse 16 mit abgenommenen Deckelelement 18. Auf dem Bodenelement 20 ist eine Anschlussvorrichtung 22 angeordnet, an die beispielsweise Anschlusskabel 24 angeschlossen sind, um den von dem Solarmodul 10 erzeugten Strom abzuführen. Die Anschlussvorrichtung 22 kontaktiert elektrisch leitend vorzugsweise L-förmige Kontaktstücke 26, die als Kupplungselemente die Anschlussvorrichtung 22 mit den Leiterbändern 14 elektrisch leitend verbinden.

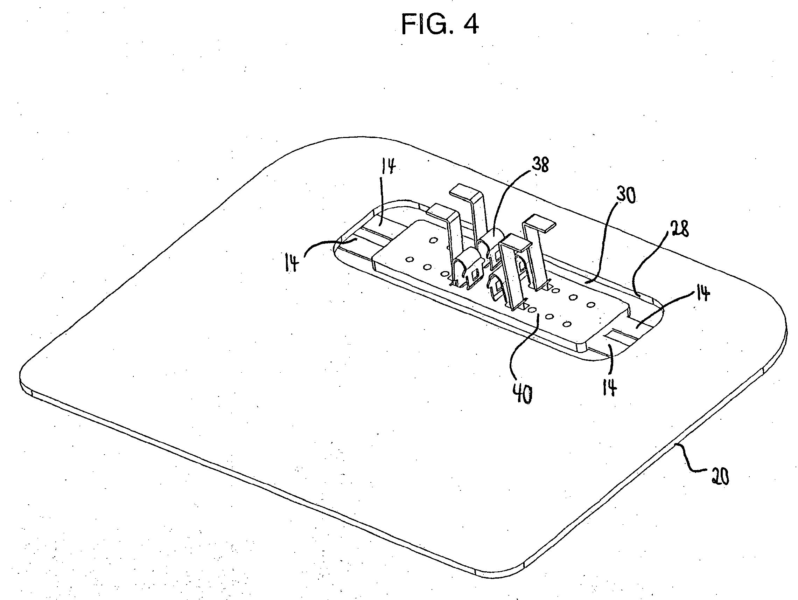

Figur 4 zeigt ebenfalls eine perspektivische Ansicht des Anschlussdosengehäuses 16, wobei hier lediglich ein Ausschnitt des Anschlussdosengehäuses 16 dargestellt ist. Das Bodenelement 20 weist vorzugsweise eine Öffnung 28 auf, über die die einzelnen Leiterbänder 14 in das Anschlussdosengehäuse 16 eingeführt werden. In dem Bereich der Öffnung 28 sind die freien Enden der Leiterbänder 14 derart angeordnet, dass sie auf der Rückseite bzw. auf der rückseitigen Fläche des Solarmoduls 10 verlaufen. Vorzugsweise handelt es sich bei der Rückseite des Solarmoduls um eine erste Laminierschicht 30 in die die einzelnen Solarzellen eingebettet sind. Bei der ersten Laminierschicht könnte es sich beispielsweise um eine witterungsfeste Kunststofffolie handeln.

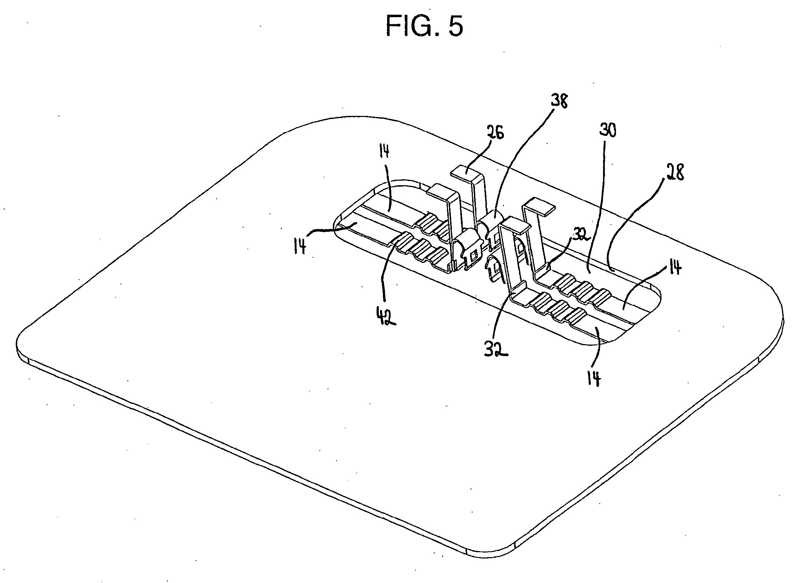

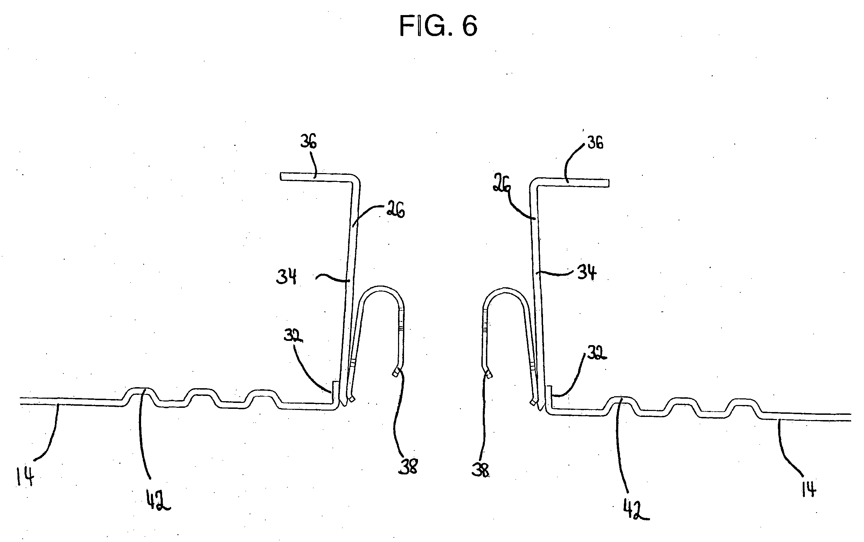

Ein vorderer Abschnitt 32 der freien Enden der Leiterbänder 14 wird, wie in den Figuren 5 und 6 gezeigt, im Wesentlichen senkrecht zu der rückwärtigen Fläche 30 des Solarmoduls 10 aufgebogen und dient als Kontaktfläche mit dem Kontaktstück 26.

Das Kontaktstück 26 weist vorzugsweise eine L-Form auf, wobei ein erstes Ende 34 des Kontaktstücks 26 den vorderen aufgebogenen Abschnitt 32 des Leiterbands 14 und das zweite Ende 36 die Anschlussvorrichtung 22 kontaktiert. Vorzugsweise ist das erste Ende 34 des Kontaktstücks 26 länger als das zweite Ende 36 des Kontaktstücks 26. Das Kontaktstück 26 ist derart an dem vorderen aufgebogenen Abschnitt 32 angeordnet, dass das erste Ende 34 des Kontaktstücks 26 im Wesentlichen senkrecht zu der rückseitigen Fläche 30 des Solarmoduls 10 und/oder parallel zu dem vorderen aufgebogenen Abschnitt 32 des Leiterbands 14 verläuft. Das zweite Ende 36 zeigt vorzugsweise rückwärts in Richtung des Leiterbands 14, wobei eine Ausrichtung in die andere Richtung ebenfalls möglich ist. Des Weiteren ist das Kontaktstück 26 aus einem Material mit hoher elektrischer Leitfähigkeit ausgeformt und ist im Wesentlichen starr.

Somit liegt eine Fläche des ersten Endes 34 des Kontaktstücks 26 an einer Fläche des vorderen aufgebogenen Abschnitts 32 des Leiterbands 14 an. Eine elektrisch leitende Kontaktierung bezüglich des zweiten Endes 36 des Kontaktstücks 26 mit der Anschlussvorrichtung 22 kann beispielsweise, wie in Figur 3 gezeigt, dadurch erfolgen, dass ein erhöhter bzw. nach oben gebogener Flächenabschnitt 23 der Anschlussvorrichtung 22 auf der oberen dem Deckelelement 18 zugewandten Fläche des zweiten Endes 36 des Kontaktstücks 26 aufliegt. Eine Fixierung der Verbindung kann durch Schrauben, Löten etc. erfolgen.

Vorzugsweise wird die Kontaktierung zwischen dem Leiterband 14 und dem Kontaktstück 26 durch ein Federelement 38, welches vorzugsweise aus Federstahl hergestellt ist, unterstützt. Ein erstes Ende des Federelements 38, das vorzugsweise eine im Wesentlichen U-Form aufweist, drückt in einem vorgespannten Zustand auf eine Fläche des Kontaktstücks 26, die der Kontaktstelle zwischen dem Leiterband 14 und dem Kontaktstück 26 entgegengesetzt liegt. Die Vorspannung des Federelements 38 kann vorzugsweise durch eine Fläche (hier nicht gezeigt) erfolgen, gegen die ein zweites Ende des Federelements 38 drückt. Diese Fläche kann beispielsweise in dem Deckelelement 18 des Anschlussdosengehäuses 16 ausgeformt sein, so dass das Federelement 38 eine Vorspannung erhält, sobald das Deckelelement 18 auf das Bodenelement 20 aufgesetzt ist bzw. das Anschlussdosengehäuse 16 geschlossen ist. Des Weiteren kann die gewünschte Vorspannung mittels eines zusätzlich eingesetzten Vorspannungselements erzeugt werden. Beispielsweise könnte hierzu ein Element zwischen zwei sich gegenüberliegenden Federelementen 38 eingesetzt werden, so dass mit einem Vorspannungselement zwei Federelemente 38 vorgespannt werden. Mittels des Federelements 38 kann sichergestellt werden, dass die elektrisch leitende Verbindung zwischen dem Leiterband 14 und dem Kontaktstück 26 dauerhaft gewährleistet ist.

Wie in Figur 4 gezeigt, wird die Kontaktstelle zwischen dem Leiterband 14 und dem Kontaktstück 26 als auch zwischen dem Kontaktstück 26 und dem Federelement 38 in eine zweite Laminierschicht 40 eingebettet und damit fest miteinander verbunden. Vorzugsweise handelt es sich bei der zweiten Laminierschicht 40 um Kunstharz, das einen besonders guten Schutz gegen eindringende Feuchtigkeit bildet oder eine weitere vorzugsweise witterungsfeste Kunststoffschicht bzw. -folie. Mittels der zweiten Laminierschicht sind, wie in Figur 4 gezeigt, die freien Enden der Kontaktstücke 14 zumindest teilweise und die oben beschriebenen Kontaktstellen zwischen dem Leiterband 14 und dem Kontaktstück 26 als auch zwischen dem Kontaktstück 26 und dem Federelement 38 in der zweiten Laminierschicht 40 angeordnet bzw. eingebettet. Da die zweite Laminierschicht 40 vorzugsweise nur im Bereich der Öffnung 28 in dem Bodenelement 20 angeordnet ist und damit direkt auf der ersten Laminierschicht bzw. dem Solarmodul 10 angeordnet ist, wirkt das Kunstharz der zweiten Laminierschicht 40 als zusätzliches Haftmittel für die Kontaktierungseinheit auf dem Solarmodul 10.

Um die Kontaktsicherheit zwischen dem Leiterband 14 und dem Kontaktstück 26 weiterhin zu verbessern, sind in einem Abschnitt des freien Endes des Leiterbands 14, welcher auf dem Solarmodul 10 und nahe dem kontaktierten Kontaktstücks 26 verläuft, zumindest eine Wölbung 42 oder Rippe, vorzugsweise drei, angeordnet. Unter dem Begriff "nahe" ist erfindungsgemäß ein Abstand von dem vorderen aufgebogenen Abschnitt 32 zu der ersten Wölbung 42 oder Rippe von etwa 1 bis 200mm, vorzugsweise von 0,3 mm bis 30 mm, zu verstehen. Die erfindungsgemäßen Wölbungen bieten einen Schutz gegen ein versehentliches Trennen der Kontaktstelle durch ein Reißen an dem Leiterband 14 während der Montage oder Wartungsarbeiten, da die Wölbungen oder Rippen eine Dehnung zulassen, ohne dass der elektrisch leitende Kontakt getrennt wird. Des Weiteren verbessern die Wölbungen oder Rippen die Fixierung des Leiterbands in der Laminierschicht.

Das erfindungsgemäße Solarmodul bietet den Vorteil, dass ein automatisiertes Kontaktieren bzw. Anschließen der Leiterbänder an eine Anschlussvorrichtung möglich wird. Mittels der vorzugsweise im Wesentlichen senkrecht zu der Rückseite des Solarmoduls 10 angeordneten Kontaktstücke 26, die im Gegensatz zu den Leiterbändern 14 starre Eigenschaften besitzen, kann die Position der Kontaktstücke 26 eindeutig bestimmt werden. Des Weiteren bieten die Anordnung und Form der Kontaktstücke 26 den Vorteil, dass die Anschlussvorrichtung 22 mittels eines Roboters trotz enger Platzverhältnisse einfach aufgesetzt werden kann und damit mit den Kontaktstücken 26 elektrisch leitend verbunden werden.

Die Leiterbänder 14 können beispielsweise durch einfaches Aufsetzen des Bodenelements 20 auf die Rückseite des Solarmoduls 10 in ihre flache Position relativ zu der Rückseite des Solarmoduls 10 gebogen werden. Anschließend oder vorab können einzelne Wölbungen 42 oder Rippen in die freien Enden der Leiterbahnen 14 geprägt werden, die eine zusätzliche Flexibilität der Leiterbänder gewähren, um ein Trennen der Kontaktstelle zwischen dem Leiterband 14 und dem Kontaktstück 26 zu verhindern. Im Anschluss können die Leiterbänder 14 an den vorzugsweise bereits vorpositionierten Kontaktstücken 26 derart angelegt werden, dass vorzugsweise automatisch der vordere aufgebogene Abschnitt 32 der Leiterbänder 14 ausgebildet wird. Überschüssiges Leiterband kann einfach abgeschnitten werden. Sobald die Federelemente an ihren entsprechenden Positionen angeordnet sind, kann die zweite Laminierschicht 40 aufgetragen werden, wodurch die einzelnen Bauteile fest miteinander verbunden werden bzw. einlaminiert werden.

### Bezugszeichenliste

- 10: Solarmodul
- 12: Solarzelle
- 14: Leiterband
- 16: Anschlussdosengehäuse
- 18: Deckelelement
- 20: Bodenelement
- 22: Anschlussvorrichtung
- 23: erhöhter Flächenabschnitt der Anschlussvorrichtung
- 24: Anschlusskabel
- 26: Kontaktstück
- 28: Öffnung
- 30: erste Laminierschicht
- 32: vorderer aufgebogener Abschnitt
- 34: erstes Ende des Kontaktstücks
- 36: zweites Ende des Kontaktstücks
- 38: Federelement
- 40: zweite Laminierschicht
- 42: Wölbung

## Patentansprüche

1. Solarmodul (10) umfassend:
eine Vielzahl von Solarzellen (12), die mit zumindest einem Leiterband (14) elektrisch leitend verbunden sind, wobei die Solarzellen (12) und das Leiterband (14) zumindest teilweise innerhalb einer Laminierschicht (30, 40) angeordnet sind, und
zumindest ein Kontaktstück (26), welches separat von dem Leiterband (14) ausgebildet ist,
wobei ein erstes Ende (34) des Kontaktstücks (26) elektrisch leitend mit einem freien Ende des Leiterbands (14) kontaktiert ist und wobei die Kontaktstelle zwischen dem Leiterband (14) und dem Kontaktstück (26) in eine Laminierschicht (40) eingebettet ist,
wobei ein zweites Ende (36) des Kontaktstücks aus der Laminierschicht (40) herausgeführt ist, und
wobei das Leiterband (14) auf einer Fläche des Solarmoduls (10) verläuft und ein vorderer Abschnitt (32) eines freien Endes des Leiterbands (14) im Wesentlichen senkrecht zu der Fläche des Solarmöduls (10) aufgebogen ist und als Kontaktfläche mit dem Kontaktstück (26) dient.

2. Solarmodul (10) nach Anspruch 1, wobei das Leiterband (14) in einem Bereich nahe dem Kontaktstück (26) zumindest eine Wölbung (42) oder Rippe aufweist.

3. Solarmodul (10) nach einem der vorhergehenden Ansprüche, ferner umfassend zumindest ein Federelement (38), wobei das Federelement das Kontaktstück (26) gegen das Leiterband (14) an deren Kontaktstelle drückt und vorzugsweise im Wesentlichen eine U-Form aufweist.

4. Solarmodul (10) nach einem der vorhergehenden Ansprüche,
wobei die Solarzellen (12) in einer ersten Laminierschicht (30) eingebettet sind, und/oder
das freie Ende des Leiterbands (14) zumindest teilweise in einer zweiten Laminierschicht (40) eingebettet ist.

5. Solarmodul (10) nach einem der vorhergehenden Ansprüche, ferner umfassend ein Anschlussdosengehäuse (16) umfassend ein Bodenelement (20), das auf dem Solarmodul (10) angeordnet ist, und eine Deckelelement (18), wobei das freie Ende des Leiterbands (14) in zumindest einer Öffnung (28) des Bodenelements (20) auf der Fläche des Solarmoduls (10) verläuft.

6. Solarmodul (10) nach Anspruch 5, wobei die zweite Laminierschicht (40) nur im Bereich der Öffnung (28) in dem Bodenelement (20) angeordnet ist.

7. Solarmodul (10) nach einem der vorhergehenden Ansprüche, wobei ein erstes Ende (34) des Kontaktstücks (26) im Wesentlichen senkrecht zu der Fläche des Solarmoduls und/oder parallel zu dem aufgebogenen Abschnitt (32) des Leiterbands (14) angeordnet ist und ein zweites Ende (36) des Kontaktstücks (26) im Wesentli= chen parallel zu der Fläche des Solarmodul (10) verläuft.

8. Solarmodul (10) nach einem der vorhergehenden Ansprüche, wobei das Kontaktstück (26) eine Anschlussvorrichtung (22) elektrisch leitend kontaktiert.

9. Verfahren zum Herstellen eines Solarmoduls (10) mit einer Vielzahl von Solarzellen (12), umfassend die Schritte:
elektrisch leitendes Verbinden der Solarzellen (12) mittels zumindest einem Leiterband (14),
Bereitstellen von zumindest einem separaten Kontaktstück (26),
elektrisch leitendes Kontaktieren eines freien Endes des Leiterbands (14) mit einem ersten Ende (34) des Kontaktstücks (26), und
Aufbringen einer Laminierschicht (30, 40) derart, dass sowohl die Kontaktstelle zwischen dem Leiterband (14) und dem Kontaktstück (26) als auch zumindest teilweise das freie Ende des Leiterbands (14) in eine Laminierschicht (40) eingebettet sind und ein zweites Ende (36) des Kontaktstücks (26) aus der Laminierschicht (40) herausragt,
wobei das Verfahren ferner den Schritt eines Biegens des freien Endes des Leiterbands (14) umfasst, so dass das Leiterband (14) auf einer Fläche des Solarmoduls (10) verläuft und ein vorderer Abschnitt (32) des freien Endes des Leiterbands (14) im Wesentlichen senkrecht zu der Fläche des Solarmoduls (10) aufgebogen ist.

10. Verfahren nach Anspruch 9, wobei das Verfahren ferner den Schritt eines Prägens zumindest einer Wölbung (42) oder Rippe in das Leiterband (14) umfasst, in einem Bereich nahe dem Kontaktstück (26).

11. Verfahren nach einem der Ansprüche 9 oder 10, wobei das Verfahren ferner die Schritte umfasst:
Bereitstellen von zumindest einem Federelement (38);
Kontaktieren des Federelements (38) mit dem Kontaktstück (26), so dass das Federelement (38) gegen eine Fläche des Kontaktstücks (26) drückt, die der Kontaktstelle zwischen dem Leiterband (14) und dem Kontaktstück (26) entgegengesetzt ist.

12. Verfahren nach einem der Ansprüche 9 bis 11, wobei der Schritt des Laminierens umfasst:
Aufbringen einer ersten Laminierschicht (30), in die die Solarzellen (12) eingebettet werden, und/oder
Aufbringen einer zweiten Laminierschicht (40), in die das freie Ende des Leiterbands (14) zumindest teilweise eingebettet wird.

## Claims

1. A solar module (10), comprising:
a plurality of solar cells (12), which are electrically conductively connected with at least one conductor strip (14), the solar cells (12) and the conductor strip (14) being arranged at least partially within a lamination layer (30, 40), and
at least one contact piece (26) formed separately from the conductor strip (14),
a first end (34) of the contact piece (26) being electrically conductively contacted with a free end of the conductor strip (14), and the point of contact between the conductor strip (14) and the contact piece (26) being embedded in a lamination layer (40),
a second end (36) of the contact piece being led out of the lamination layer (40), and
the conductor strip (14) extending on a surface of the solar module (10), and a front portion (32) of a free end of the conductor strip (14) being bent upward substantially perpendicular to the surface of the solar module (10) and serving as a surface of contact with the contact piece (26).

2. The solar module (10) according to claim 1, wherein the conductor strip (14) comprises at least one bulge (42) or rib in an area near the contact piece (26).

3. The solar module (10) according to any one of the preceding claims, further comprising at least one spring element (38), the spring element pressing the contact piece (26) against the conductor band (14) at their place of contact, and preferably having substantially a U-shape.

4. The solar module (10) according to any one of the preceding claims,
wherein the solar cells (12) are embedded in a first lamination layer (30), and/or
the free end of the conductor strip (14) being embedded at least partially in a second lamination layer (40).

5. The solar module (10) according to any one of the preceding claims, further comprising a connection socket housing (16) comprising a bottom element (20) arranged on the solar module (10), and a lid member (18), the free end of the conductor strip (14) extending in at least one opening (28) of the bottom member (20) on the surface of the solar module (10).

6. The solar module (10) according to claim 5, wherein said second lamination layer (40) is arranged only in the region of the opening (28) in the base element (20).

7. The solar module (10) according to any one of the preceding claims, wherein a first end (34) of the contact piece (26) is disposed substantially perpendicular to the surface of the solar module and/or in parallel to the bent-up portion (32) of the conductor strip (14), and a second end (36) of the contact piece (26) is substantially parallel to the surface of the solar module (10).

8. The solar module (10) according to any one of the preceding claims, wherein the contact piece (26) electrically conductively contacts a connecting device (22).

9. A method for producing a solar module (10) having a plurality of solar cells (12), comprising the steps of:
electrically conductively contacting the solar cells (12) by means of at least one conductor strip (14),
providing at least one separate contact element (26),
electrically conductively contacting a free end of the conductor strip (14) to a first end (34) of the contact piece (26), and
applying a lamination layer (30, 40) such that both, the contact point between the conductor strip (14) and the contact piece (26), and at least part of the free end of the conductor strip (14) are embedded in a lamination layer (40), and a second end (36) of the contact piece (26) protruding from the lamination layer (40),
the method further comprising the step of bending the free end of the conductor strip (14) so that the conductor strip (14) extends on a surface of the solar module (10) and a front portion (32) of the free end of the conductor strip (14) is bent upward substantially perpendicular to the surface of the solar module (10).

10. The method of claim 9, the method further comprising the step of embossing at least one bulge (42) or rib in the conductor strip (14) in an area near the contact piece (26).

11. The method according to any one of claims 9 or 10, the method further comprising the steps of:
providing at least one spring element (38);
connecting the spring element (38) with the contact piece (26) so that the spring element (38) presses against a surface of the contact piece (26) opposite to the point of contact between the conductor strip (14) and the contact piece (26).

12. The method according to any one of claims 9 to 11, wherein the step of laminating comprises:
applying a first lamination layer (30), in which the solar cells (12) are embedded, and/or
depositing a second lamination layer (40), in which the free end of the conductor strip (14) is at least partially embedded.

## Revendications

1. Module solaire (10) comprenant :
une pluralité de cellules solaires (12) qui sont reliées de manière électriquement conductrice à au moins une bande conductrice (14), dans lequel les cellules solaires (12) et la bande conductrice (14) sont disposées au moins partiellement au sein d'une couche stratifiée (30, 40), et
au moins une pièce de contact (26) qui est réalisée séparément de la bande conductrice (14),
dans lequel une première extrémité (34) de la pièce de contact (26) vient en contact de manière électriquement conductrice avec une extrémité libre de la bande conductrice (14) et dans lequel le point de contact entre la bande conductrice (14) et la pièce de contact (26) est encastré dans une couche stratifiée (40),
dans lequel une seconde extrémité (36) de la pièce de contact est sortie de la couche stratifiée (40), et
dans lequel la bande conductrice (14) s'étend sur une face du module solaire (10), et une section avant (32) d'une extrémité libre de la bande conductrice (14) est dépliée essentiellement perpendiculairement à la face du module solaire (10) et sert de face de contact avec la pièce de contact (26).

2. Module solaire (10) selon la revendication 1, dans lequel la bande conductrice (14) présente dans une région proche de la pièce de contact (26) au moins un bombement (42) ou une nervure.

3. Module solaire (10) selon une des revendications précédentes, comprenant en outre au moins un élément de ressort (38), dans lequel l'élément de ressort pousse la pièce de contact (26) contre la bande conductrice (14) au niveau de leur point de contact et présente de préférence essentiellement une forme de U.

4. Module solaire (10) selon une des revendications précédentes,
dans lequel les cellules solaires (12) sont encastrées dans une première couche stratifiée (30), et/ou
l'extrémité libre de la bande conductrice (14) est au moins partiellement encastrée dans une seconde couche stratifiée (40).

5. Module solaire (10) selon une des revendications précédentes, comprenant en outre un logement de boîte de jonction (16) comprenant un élément de fond (20) qui est disposé sur le module solaire (10) et un élément de recouvrement (18), dans lequel l'extrémité libre de la bande conductrice (14) s'étend dans au moins une ouverture (28) de l'élément de fond (20) sur la face du module solaire (10).

6. Module solaire (10) selon la revendication 5, dans lequel la seconde couche stratifiée (40) est uniquement disposée dans la région de l'ouverture (28) dans l'élément de fond (20).

7. Module solaire (10) selon une des revendications précédentes, dans lequel une première extrémité (34) de la pièce de contact (26) est disposée essentiellement perpendiculairement à la face du module solaire et/ou parallèlement à la section dépliée (32) de la bande conductrice (14) et une seconde extrémité (36) de la pièce de contact (26) s'étend essentiellement parallèlement à la face du module solaire (10).

8. Module solaire (10) selon une des revendications précédentes, dans lequel la pièce de contact (26) vient en contact de manière électriquement conductrice avec un dispositif de raccordement (22).

9. Procédé de fabrication d'un module solaire (10) avec une pluralité de cellules solaires (12), comprenant les étapes :
connexion électriquement conductrice des cellules solaires (12) au moyen d'au moins une bande conductrice (14),
mise à disposition d'au moins une pièce de contact séparée (26),
mise en contact électriquement conductrice d'une extrémité libre de la bande conductrice (14) avec une première extrémité (34) de la pièce de contact (26), et application d'une couche stratifiée (30, 40) de telle sorte qu'aussi bien le point de contact entre la bande conductrice (14) et la pièce de contact (26) qu'au moins partiellement l'extrémité libre de la bande conductrice (14) sont encastrés dans une couche stratifiée (40), et une seconde extrémité (36) de la pièce de contact (26) dépasse de la couche stratifiée (40),
dans lequel le procédé comprend en outre l'étape d'un pliage de l'extrémité libre de la bande conductrice (14) de sorte que la bande conductrice (14) s'étend sur une face du module solaire (10) et une section avant (32) de l'extrémité libre de la bande conductrice (14) est dépliée essentiellement perpendiculairement à la face du module solaire (10).

10. Procédé selon la revendication 9, dans lequel le procédé comprend en outre l'étape d'un estampage d'au moins un bombement (42) ou d'une nervure dans la bande conductrice (14) dans une région proche de la pièce de contact (26).

11. Procédé selon une des revendications 9 ou 10, dans lequel le procédé comprend en outre les étapes :
mise à disposition d'au moins un élément de ressort (38) ;
mise en contact de l'élément de ressort (38) avec la pièce de contact (26) de sorte que l'élément de ressort (38) pousse contre une face de la pièce de contact (26) qui est opposée au point de contact entre la bande conductrice (14) et la pièce de contact (26).

12. Procédé selon une des revendications 9 à 11, dans lequel l'étape de la stratification comprend :
application d'une première couche stratifiée (30) dans laquelle les cellules solaires (12) sont encastrées, et/ou
application d'une seconde couche stratifiée (40) dans laquelle l'extrémité libre de la bande conductrice (14) est au moins partiellement encastrée.
